# FASCICULE DE BREVET EUROPEEN

(11) **EP 2 523 537 B1**
(45) Date de publication et mention de la délivrance du brevet: **27.11.2013**
(21) Numéro de dépôt: 12164758.0
(22) Date de dépôt: 19.04.2012
(51) Int. Cl.: H05K 7/14, E04H 5/00, E04H 1/12

(54) **Unité modulaire pour la construction de centres de données informatiques**
Moduleinheit für den Bau von Informatikdatenzentren
Modular unit for the construction of computer data centres

(30) Priorité: 12.05.2011 FR 1154122
(43) Date de publication de la demande: 14.11.2012
(73) Titulaire: IP Energy, 13120 Gardanne (FR)
(72) Inventeur: Febvre, Rémy, 13109 Simiane-Collongue (FR)
(74) Mandataire: Domange, Maxime

(56) Documents cités:
- WO-A1-2011/038348
- US-A1- 2006 082 263
- US-A1- 2009 229 194

## Description

### Arrière-plan de l'invention

La présente invention se rapporte au domaine général des unités modulaires pour la construction de centres de données informatiques.

Les centres de données sont aujourd'hui le moteur et le support d'une informatique qui est désormais au coeur de l'économie. Aujourd'hui les risques de conception doivent être réduits au maximum. La sécurisation des centres de données est un enjeu majeur. Cette sécurisation doit intégrer à la fois les aspects physiques et informatiques.

D'un point de vue physique, la densité élevée des matériels informatiques oblige à une installation dans des bâtiments présentant une résistance mécanique suffisante. Cependant, il arrive couramment aujourd'hui que des serveurs soient installés dans des locaux quelconques à destination de bureaux mais non à destination d'hébergement de matériels informatiques. De tels locaux ne sont généralement pas adaptés pour supporter les masses importantes que représentent les serveurs et autres matériels informatiques. Il existe aujourd'hui un besoin pour des bâtiments dédiés.

En parallèle de la nécessaire gestion des risques et des exigences du domaine, on remarque des besoins informatiques en augmentation constante. On observe effectivement une augmentation exponentielle de la densité de puissance avec la virtualisation. On sait par ailleurs que certains des retards pris dans l'utilisation de la virtualisation vont entraîner un rattrapage qui va accroitre la demande en centres de données de manière très importante.

Il est de plus en plus courant d'externaliser les centres de données, ce qui résulte en un éclatement international des systèmes d'information avec des problèmes de sécurité afférents et en des couts de gestion importants. Il existe donc un besoin pour des solutions locales. Cela permet aussi de construire une salle informatique en fonction de la localisation des branchements réseau.

Par ailleurs, les arrêts de centres de données étant particulièrement critiques, on constate aujourd'hui que la norme s'établit à 99,99 % de disponibilité du centre de données, c'est-à-dire de 52 mn d'indisponibilité par an. La disponibilité doit aussi pouvoir être conservée dans le temps. Néanmoins, la disponibilité doit rimer avec un prix acceptable pour être viable et potentiellement étendu à de nombreuses applications.

Actuellement, les évolutions des centres de données impliquent, en amont, une analyse de risques préalable personnalisée et l'établissement d'un prévisionnel prévoyant les futurs besoins en fonction du fonctionnement présent. Cela est un processus couteux et n'évite pas systématiquement d'avoir à agrandir un centre de données ultérieurement à sa mise en production.

En effet, les centres de données doivent répondre aux besoins particuliers de chacun des exploitants. Il reste impératif de s'adapter au contexte des exploitants. Ainsi, il est peu souhaitable d'implémenter une salle trop grande nécessitant une climatisation trop puissante pour un besoin modeste. Cela engendre des coûts très élevés non justifiés, même si, dans ce cas, la possibilité de faire évoluer le centre de données est assurée.

Aujourd'hui, pour étendre la surface d'un centre de données en production, des indisponibilités du centre de données sont généralement inéluctables.

Il existe donc un besoin important pour des conceptions de centres de données incluant des moyens de protection et de construction non destructifs sur l'exploitation informatique. Ainsi, l'invention répond à ces contraintes d'exploitation qui rendent nécessaires des possibilités d'évolution rapide et sans intervention extérieure sur les éléments en production.

En tenant compte du fait que l'on a encore malgré tout une vue peu claire sur les besoins informatiques futurs, il reste raisonnable de construire des salles ajustées aux besoins. En revanche, cela nuit au caractère évolutif de la construction. Il existe donc un besoin d'évolutivité des salles informatiques permettant d'optimiser les coûts.

Une infrastructure mal optimisée génère un excès de consommation préjudiciable, notamment en termes de climatisation. L'invention s'insère dans la nécessité d'une conception éco-énergétique pensée en amont en ajustant la taille des centres de données et en permettant leur évolution. Certains spécialistes des centres de données se sont ainsi penchés sur l'utilisation d'unités modulaires du type container de transport de marchandise ou bungalows de chantier.

Généralement, ces unités modulaires sont de forme parallélépipédique. Il existe à ce jour une pluralité de solutions pour la mise en oeuvre de salles informatiques, à partir d'une unité modulaire.

Par exemple, le document US 7 278 273 décrit la création de centres de données informatiques à partir de modules longitudinaux reliés par leurs extrémités par des modules transversaux. Dans ces modules, les appareillages informatiques sont classiquement installés le long des parois dans le sens longitudinal des unités modulaires. L'espace obtenu est complexe et l'utilisation de modules transversaux est nécessaire dès lors qu'un module additionnel doit être installé. La construction est donc complexe.

Le document US 2005/0235671 décrit l'utilisation d'une pluralité de rangées de rayonnages pour accueillir des appareillages informatiques dans un local rectangulaire. Dans ce document, les rayonnages sont placés de manière transversale par rapport à l'axe longitudinal du local. Ce document s'intéresse à la circulation de l'air au sein d'un local informatique mais n'envisage pas d'assemblage de plusieurs locaux comprenant des appareillages informatiques.

Le document WO 2010/0132896 décrit, quant à lui, l'utilisation d'unités modulaires dont, pour certains, les parois latérales ont été supprimées afin de pouvoir former une grande salle informatique à partir de plusieurs modules. Aucune évolution de la taille de la salle informatique ainsi construite n'est envisagée. La figure 5 de ce document montre l'implantation des rayonnages de manière classique dans une grande salle informatique. Les accès humains sont répartis sur la périphérie de la salle ainsi obtenue.

Enfin, le document US 2009/229194 décrit un module de forme parallélépipédique dans lequel les rayonnages sont installés dans le sens longitudinal, ainsi que cela est visible sur les figures 4A, 4B et 11. Les figures 17, 21 et 22 montrent l'accouplage de plusieurs unités modulaires. On voit que les parois des unités modulaires ont été totalement supprimées au sein de la salle informatique ainsi obtenue. Ce document est donc comparable au précédent.

Le document WO 2011/038348 divulgue une unité modulaire pour la construction de centres de données informatiques parallélépipédique qui comprend les caractéristiques du préambule de la revendication 1.

Dans ces deux derniers documents, la salle est conçue dès le départ avec l'installation des modules. Pour ajouter une unité modulaire, une rupture des conditions internes de la salle est indispensable pour découper la paroi d'un des modules en production avant d'amener un autre module adjacent. Cela implique classiquement un arrêt des systèmes informatiques fonctionnant initialement pour réaliser l'ajout d'un autre module. Il est ensuite indispensable de découper la paroi du premier module afin d'ouvrir l'accès entre les deux modules.

Ainsi, avec aucun des dispositifs connus, un simple accouplage de deux modules n'est pas envisagé. En outre, on constate qu'aucun des systèmes décrits dans les arts antérieurs ne prévoient l'ajout de modules sur un autre module en production. L'ajout d'un module ne peut se faire qu'avec dégradation de la situation au sein du premier module en termes de poussière et/ou de condition en température et en pression. Cela est très préjudiciable car l'arrêt des équipements informatiques au sein d'un centre de données est alors nécessaire et s'avère problématique.

Il n'est pas connu à ce jour de système permettant un accouplage à chaud de plusieurs unités modulaires pour former un centre de données informatiques agrandi sans avoir à arrêter les équipements informatiques qui fonctionneraient dans un module initial.

### Objet et résumé de l'invention

La présente invention a donc pour but principal de pallier les inconvénients des unités modulaires connues de l'art antérieur en proposant une unité modulaire pour la construction de centres de données informatiques de forme parallélépipédique, cette unité étant destinée à être installée seule ou en groupement avec d'autres unités modulaires identiques par un accouplage latéral réalisé sur la longueur des unités modulaires, cette unité comprenant, au sein de son espace interne, au moins une rangée de rayonnages aptes à recevoir des appareillages informatiques actifs et passifs, cette rangée étant aménagée dans la largeur de l'unité modulaire et définissant ainsi au moins un nombre d'allées parallèles égal au nombre de rangées plus une, ces allées étant séparées par la ou lesdites rangée(s), l'unité modulaire comprenant en outre autant d'ouvertures latérales que d'allées de part et d'autre de l'unité modulaire, ces ouvertures étant aptes à être équipées soit par un dispositif d'ouverture/fermeture permettant un accès humain à l'allée correspondante, soit par un dispositif d'obturation démontable après l'accouplage avec une autre unité modulaire et après jointement des deux unités modulaires pour permettre d'ouvrir la circulation dans les deux allées correspondantes des deux unités modulaires accouplées qui sont alors dans la continuité l'une de l'autre.

Les unités modulaires ou modules selon l'invention sont conçues pour pouvoir être indifféremment installées seules ou en combinaison avec d'autres unités sans aucune modification structurelle et, au besoin, par seul démontage de parois amovibles placées sur des ouvertures prévues à cet effet, ce démontage étant effectué après accouplage et jointement des deux unités.

L'utilisation de dispositifs d'obturation pouvant être ôtés après accouplage de deux unités modulaires de manière à former des allées entre les rangées de rayonnages, permet d'agrandir un centre de données informatiques sans avoir à arrêter les appareillages informatiques qui seraient déjà installés dans une première unité modulaire.

En effet, le fait de prévoir expressément des parois amovibles après accouplage sur une unité modulaire, permet d'enlever ces parois d'obturation sans avoir à introduire de poussière et sans modifier les conditions climatiques au sein du premier module.

Avec l'invention, on rend possible la mise en condition climatique de la seconde unité modulaire accouplée à la première avant de procéder au démontage des dispositifs d'obturation, ce démontage ouvrant alors les allées au sein du centre de données informatiques.

L'assemblage de deux unités modulaires se fait en juxtaposant deux unités modulaires par leur côté. Une étanchéisation complète de la deuxième unité modulaire est ensuite réalisée avant que ne soient ouvertes les nouvelles allées résultant de l'assemblage, en démontant les dispositifs d'obturation. Une caractéristique essentielle de l'invention est donc que les parois du premier module en production puissent être retirées après accouplage et étanchéisation.

Ce rattachement inter-modulaire permet un accouplage, même durant la phase de production d'un premier module. Il est ainsi possible, à partir d'une pluralité d'unités modulaires d'obtenir une véritable salle informatique, conforme aux exigences et bonnes pratiques des centres de données et de la faire évoluer au besoin.

Pour obtenir une salle informatique, il est, en effet, par ailleurs connu de munir des modules du type container d'une alimentation, d'un système de refroidissement, d'un système d'incendie et air, d'une supervision, d'une sécurité d'accès ainsi que des infrastructures spécifiques aux systèmes d'information.

L'objet de l'invention permet ainsi des agrandissements du centre de données de manière très souple et adaptables quasiment à l'infini sans avoir à arrêter une unité modulaire en production.

Des déploiements rapides sur quelques mois et évolutifs peuvent ainsi être réalisés. En effet, la mise en oeuvre de l'invention permet de ne pas impacter la production grâce au concept d'éléments d'obturation retirables à chaud. L'invention permet ainsi des décisions rapides d'implémentation de centres de données pour un coût moindre. Avec l'invention, la mise à disposition de la salle informatique est très rapide tandis que les moyens de mise en production se situent autour de 4 à 6 mois contre 15 à 18 mois minimum actuellement. De plus, l'invention, ouvrant des allées parallèles dans la salle informatique obtenue, permet une très bonne utilisation de l'espace.

L'invention répond parfaitement aux besoins de l'informatique actuels et futurs. Il est en plus possible de déplacer toute ou partie du bâtiment au besoin. L'invention présente donc l'avantage d'être, en même temps, une solution rapidement déployable et transportable.

En évitant la construction de salles surdimensionnées en prévision des évolutions future, l'invention permet par ailleurs d'optimiser la consommation énergétique. L'invention répond également aux principes « PLUG & PLAY » reconnus comme étant particulièrement avantageux dans de nombreux domaines. Dans le cadre de l'invention, ce principe consiste en un assemblage à chaud des modules successifs. L'invention est effectivement un concept clef en mains optimisé qui permet une conception industrialisée. Cela réduit considérablement les phases d'ingénierie et de génération des cahiers des charges tout en respectant l'état de l'art en matière de centres de données.

L'invention permet également une esthétique adaptable sur mesure à chaque environnement architectural grâce à des bardages externes de matériaux très divers disponibles sur le marché de plusieurs fabricants. Ces bardages pouvant être fixés facilement sur les parois externes de chaque unité.

Grâce à l'évolutivité et la souplesse accessible, l'invention permet d'avoir une optique de gestion et d'exploitation évolutive et ce dès la conception d'origine. Elle protège les investissements selon les principes de paiement à l'extension. Il est en effet possible de faire évoluer rapidement les dimensions du centre de données à partir de 15 m².

La personnalisation permise par l'invention est maximale pour les hébergeurs. La facturation de l'installation de la salle d'informatique est en fonction des caractéristiques demandées par chaque client. L'invention permet de réduire les premiers investissements massifs pour la construction d'un centre de données. En revanche, elle conserve une très grande rapidité de déploiement et un retour sur investissement qui est donc rapide.

L'invention permet aussi de monter et d'adapter le centre de données sans intervention extérieure, ce qui entraîne une très grande autonomie. L'invention permet de coupler une forte industrialisation et une grande souplesse. Le centre de données est alors au plus près des besoins des clients. Chaque unité modulaire peut en plus être personnalisée ainsi que chaque rayonnage installé au sein du module. Les coûts globaux en sont sensiblement réduits.

En effet, le nombre d'unités modulaires peut être augmenté selon les besoins, des salles privatisées et sécurisées peuvent être mises en oeuvre, des salles mutualisées avec des zones de densité de puissance différentes peuvent également être installées. La solution ne présente pas de limitation spécifique pour les tailles de serveurs et présente donc une universalité permettant de recevoir tous types de serveurs.

On note aussi que l'invention permet l'utilisation d'unités modulaires pour des fonctions dédiées, outre les unités modulaires comportant des rangées de rayonnages aptes à accueillir les équipements informatiques. Ces unités modulaires spécifiques pourront être dédiées, notamment à la puissance, à la fabrication du froid, à une unité de pilotage et de surveillance, etc... Ces fonctions pourront être implémentées dans des modules de début de montage et des modules intermédiaires au montage et des modules de fin de montage.

L'invention permet d'obtenir une grande efficacité énergétique et de conserver la surface et la puissance toujours la plus adaptée. Elle permet l'installation de capacités de refroidissement adaptées de 3 à 40 watts par rayonnage et une grande évolutivité en terme de puissance électrique jusqu'à 4 X 32 ampères/rayonnage. Cela permet d'optimiser les dépenses énergétiques.

L'invention permet un réel retour sur investissement du point de vue des coûts d'exploitation qu'elle permet d'optimiser, de connaître et de maîtriser dès le départ.

Selon une caractéristique avantageuse, l'unité modulaire présente un dimensionnement parallélépipédique externe satisfaisant, au moins en longueur, à l'un des standards dimensionnels en vigueur pour les containers de transport de marchandises ou pour les bungalows de chantier.

Cette caractéristique autorise le transport aisé des unités modulaires selon l'invention par camion, bateau, etc... à la manière dont sont transportés les containers ou bungalows selon l'un des standards existants.

Les formats pourront être notamment autour de 10, 20, 30 ou 40 pieds tels que connus pour les modules de bungalows de chantier ou les containers de transport de marchandises qui sont des containers à destinations multiples. La mise en oeuvre de l'invention permet donc de proposer, notamment, des unités modulaires d'une dizaine à une quarantaine de mètres carrés assemblables à chaud pour créer des grands ensembles. Typiquement le nombre d'ouvertures de part et d'autre des unités modulaires sera d'autant plus important que l'unité modulaire sera longue.

Selon une caractéristique préférentielle de l'invention, les dispositifs d'obturation sont démontables par l'intérieur de l'unité modulaire.

Cette caractéristique permet de venir accoupler le second module puis, ensuite, d'enlever les dispositifs d'obturation de la première unité modulaire de l'intérieur de celle-ci après étanchéisation. En effet, puisque le premier module, ou l'ensemble de premiers modules, déjà en production est nécessairement accessible pour un humain, le démontage du dispositif d'obturation est ainsi nécessairement possible. Cela est particulièrement utile lorsque l'unité ajoutée est démunie de dispositifs d'ouverture/fermeture pour un accès humain et ne possède que des dispositifs d'obturation sur la face opposée à la face accouplée. Cela est aussi utile du point de vue de la sécurité puisque l'on évite la possibilité de vandalisme par démontage malintentionné des dispositifs d'obturation par l'extérieur de l'unité modulaire. Cette caractéristique est donc particulièrement avantageuse et préférentielle au vu des avantages ci-dessus même si d'autres réalisations pourront être mises en oeuvre. Dans ces autres réalisations, les dispositifs d'obturation pourraient notamment être amovibles aussi bien de l'extérieur que de l'intérieur.

Selon une caractéristique particulière, la ou les rangées est(sont) telle(s) que les allées sont ouvertes les unes sur les autres et définissent ainsi un seul espace thermique continu et confiné.

Cette caractéristique assure l'obtention d'un unique espace froid dans la salle informatique obtenue. Elle est intéressante notamment dans le cas d'utilisation de portes froides. En effet, toutes les allées de l'unité modulaire sont alors des allées froides. La caractéristique d'allées ouvertes les unes sur les autres permets une gestion des conditions climatiques au sein du module ou de l'assemblage de modules de la même manière pour la totalité de l'espace intérieur. Cette caractéristique permet de mutualiser les systèmes climatiques pour l'ensemble des allées. Ainsi, l'invention est aussi très efficace dans le cas de l'utilisation de dispositifs de refroidissement dit à « portes froides » directement intégrés aux rayonnages à l'arrière des serveurs rejetant l'air réchauffé vers ces dispositifs qui peuvent être passifs ou actifs (avec ou sans ventilation intégrée).

Selon une caractéristique avantageuse, la (ou les rangées) est(sont) telle(s) que les allées sont isolées les unes des autres, les allées définissant alors des espaces thermiques distincts.

Cette caractéristique permet de définir plusieurs espaces thermiques au sein de l'unité modulaire et, ainsi, d'optimiser au besoin la gestion thermique au sein du centre de données.

Selon une mise en oeuvre préférentielle, les appareillages informatiques sont disposés dans les rayonnages de telle manière que les allées sont en alternance chaudes et froides sur la longueur de l'unité modulaire.

En effet, il est reconnu que, en l'absence de dispositifs de refroidissement spécifiques au niveau des rayonnages, l'utilisation d'allées chaudes et froides en alternance s'avère particulièrement avantageuse. En effet, typiquement, en l'absence de portes froides sur les rayonnages, l'utilisation d'allées chaudes et froides permet une optimisation de la gestion thermique au sein des centres de données.

On remarque aussi que l'invention permet de conserver directement et très simplement, sans aménagement spécifique, l'alignement des allées froides et chaudes lors de l'évolution du centre de données par accouplage d'unités modulaires complémentaires. Cela est très avantageux.

L'invention, basée sur un concept de prolongation d'allées transversales à l'axe longitudinal des unités modulaires, permet ainsi une gestion d'air en mode rayonnages. Cela permet un déploiement facilité des modules du point de vue de la gestion climatique. L'obtention des allées chaudes et froides est alors directement conforme et aux bonnes pratiques des centres de données. Les trois caractéristiques précédentes montrent que la construction de centre de données avec des modules selon l'invention permet un choix de technologie de refroidissement très libre et optimal en fonction des besoins et de l'évolution des technologies. Ainsi, l'évolutivité et l'adaptabilité de la construction selon l'invention tient compte de l'évolution des moyens de dissipation thermique et des caractéristiques des machines, par exemple lorsque celles-ci mettent en oeuvre un refroidissement latéral (portes froides ou autres).

L'invention concerne également un procédé de construction d'un centre de données informatiques évolutif, comprenant les étapes suivantes :
- installation d'une première unité modulaire selon l'invention, les ouvertures de cette unité étant munies, d'un côté, de dispositifs d'ouverture/fermeture, et de l'autre côté, de dispositifs d'obturation démontables ;
- mise en atmosphère convenable de l'espace interne de la première unité modulaire ;
- installation et mise en route d'appareillages informatiques ;
   les étapes suivantes étant réalisées en fonction des besoins d'évolution du centre de données, sans nécessiter d'arrêt interruption de fonctionnement des appareillages informatiques installés dans la première unité modulaire déjà installées et assemblées :
- amenée d'une deuxième unité modulaire selon l'invention, présentant le même nombre d'ouvertures que la première unité, latéralement contre la face de la première unité modulaire munie de dispositifs d'obturation, cette deuxième unité modulaire étant munie, sur la face opposée à la face amenée contre la première unité modulaire, soit de dispositifs d'obturation, soit de dispositifs d'ouverture/fermeture ;
- accouplage des deux unités modulaires avec jointement au niveau des deux faces amenées l'une contre l'autre ;
- interconnexion des réseaux électriques, hydrauliques et de contrôle des deux unités sans arrêter le fonctionnement des unités déjà en fonction ;
- démontage des dispositifs d'obturation avant ou après une mise en atmosphère convenable de l'espace interne de la deuxième unité modulaire.

Un tel procédé de construction utilise les caractéristiques des unités modulaires selon l'invention pour permettre la construction de centres de données évolutifs avec réactivité, fiabilité, souplesse, efficacité et professionnalisme.

En effet, l'invention permet d'assurer une haute disponibilité en conservant un ou plusieurs modules en production alors même que l'on fait évoluer la taille du centre de données. L'invention assure ainsi la sécurité du fonctionnement tout en assurant une évolutivité maximale du centre de données.

La conception, la construction et l'agrandissement des centres de données sont ainsi réalisés en optimisant les paramètres écologiques et économiques.

Enfin, l'invention concerne un centre de données informatiques réalisé selon un procédé de l'invention à partir d'unités modulaires selon l'invention, ce centre de données présentant une pluralité d'allées parallèles transversales aux axes longitudinaux des unités modulaires, ces allées étant ouvertes au travers des ouvertures des unités modulaires dépourvues de dispositifs d'obturation et de dispositifs d'ouverture/fermeture.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif. Sur les figures :

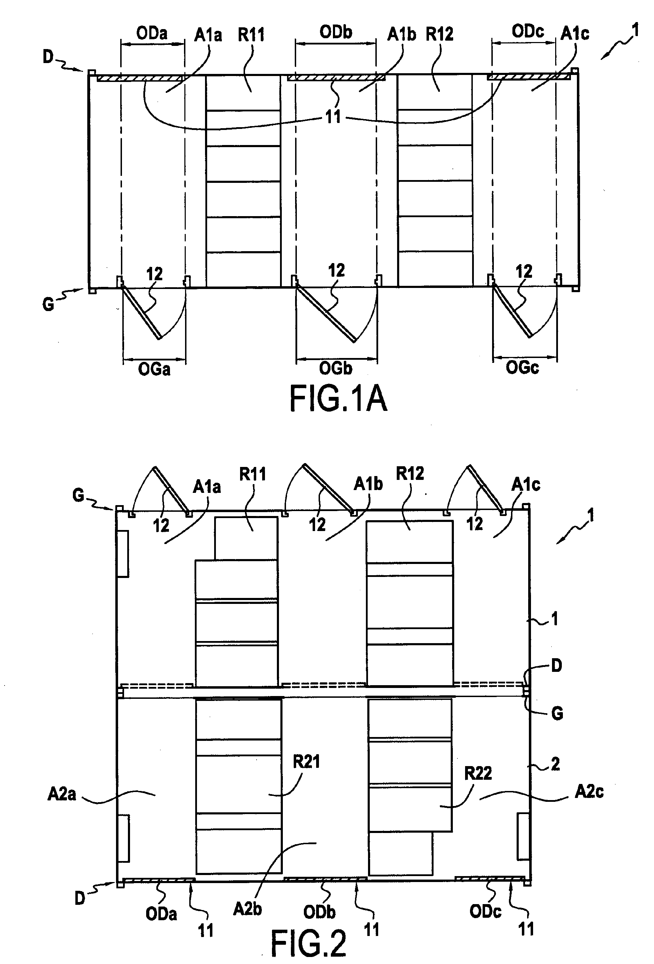

- les figures 1A à 1C montrent une unité modulaire selon l'invention, respectivement en vue de dessus, vue en perspective latérale gauche et latérale droite et vue de détail ;
- la figure 2 montre un assemblage de deux unités modulaires selon l'invention après accouplage ;

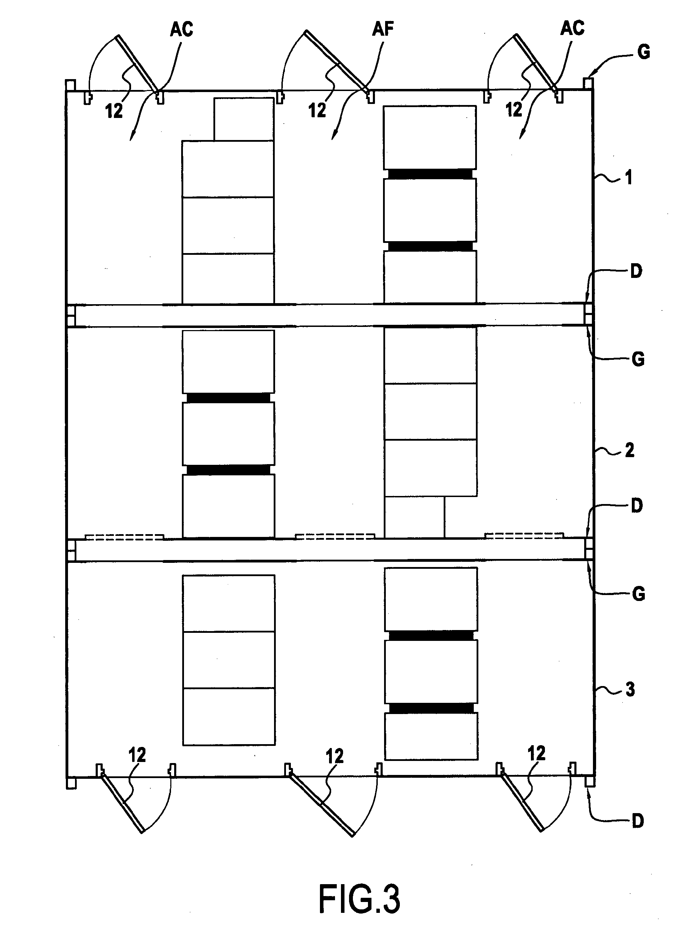

- la figure 3 montre un autre assemblage cette fois de trois unités modulaires selon l'invention ;

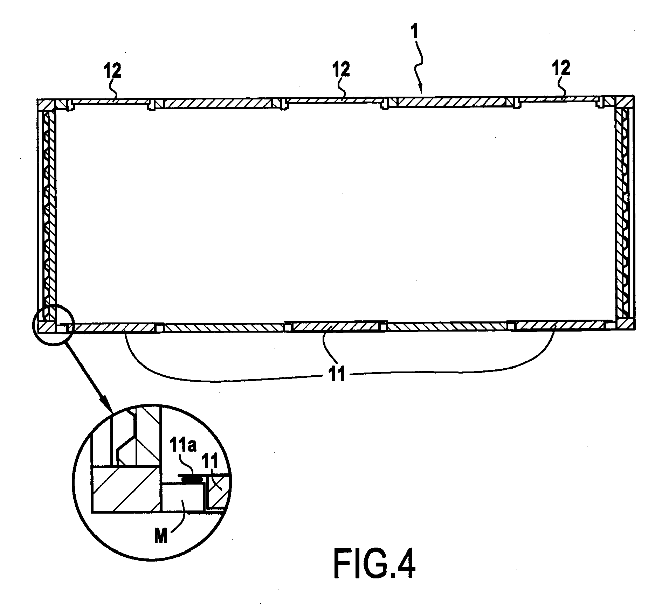

- la figure 4 montre un détail du montage d'un dispositif d'obturation sur le contour d'une ouverture d'une unité modulaire selon l'invention.

### Description détaillée d'un mode de réalisation

La figure 1A montre un module 1 muni de trois ouvertures ODa, ODb et ODc sur son côté droit noté D et trois ouvertures OGa, OGb et OGc sur son côté gauche, noté G.

Les ouvertures de l'unité modulaire 1 sont obturées par des dispositifs d'obturation amovibles notés 11 sur le côté droit D.

Sur le côté gauche G, les ouvertures sont munies de dispositifs d'ouverture/fermeture permettant un accès humain 12. Ces dispositifs d'ouverture/fermeture 12 sont typiquement des portes, ici des portes ouvrant vers l'extérieur de l'unité modulaire 1.

L'unité modulaire 1 comprend deux rangées R11 et R12 de rayonnages, ou racks en anglais, aptes à recevoir des appareillages informatiques actifs et/ou passifs. Ces rangées R11 et R12 sont transversales par rapport à l'axe longitudinal de l'unité modulaire 1. Ces rangées définissent trois allées A1a, A1b, A1c entre elles et les parois avant et arrière de l'unité modulaire 1.

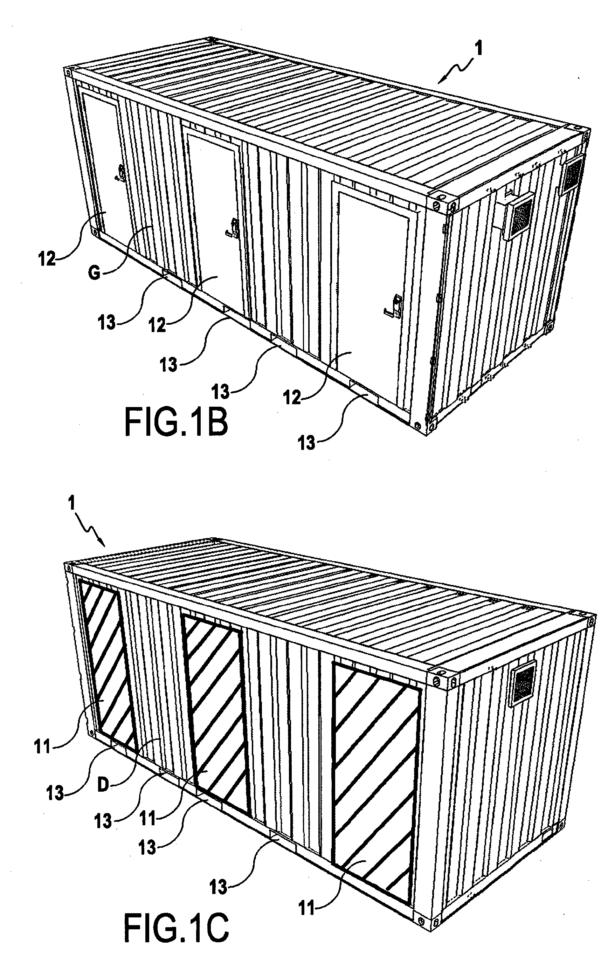

La figure 1B montre le côté gauche G de l'unité modulaire 1 avec les trois portes 12.

La figure 1C montre le côté droit D de l'unité modulaire 1 avec les dispositifs d'obturation 11. Le procédé de construction selon l'invention consiste à amener une autre unité modulaire 2 présentant des ouvertures identiques contre ce côté droit D.

Ce côté droit D présente des orifices 13 de passage de câbles et/ou de circuit d'eau situés au niveau des allées formées par les rangées. Ces orifices 13 sont situés de manière à se trouver sous un plancher s'étendant au niveau du bas des portes 12. Ces orifices 13 sont avantageusement obturés lorsque l'unité modulaire 1 est utilisée seule. Ils sont ouverts au moment de l'accouplage des unités. Aussi, avantageusement les deux côtés des modules en sont munis. Ils sont destinés à se faire face lors de l'accouplage avec un autre module.

Leur ouverture est réalisée de préférence après accouplage, par exemple à l'aide d'un accès sous des dalles du plancher. Ils peuvent éventuellement aussi être ouverts avant l'accouplage étant donné que l'introduction de poussières est moins critique au niveau des circulations électriques et hydrauliques qu'au niveau des serveurs. D'autres orifices spécifiques, par exemple pour le passage des câbles de connectique réseau, pourront être installés avec des dispositifs d'obturation amovibles. Dès lors que ces orifices déboucheront sur l'intérieur de la salle informatique, les dispositifs d'obturation seront amovibles après accouplage des unités modulaires.

La figure 2 montre deux unités modulaires 1 et 2 accouplées. Cet accouplage a été réalisé par amenée de l'unité modulaire 2 contre la paroi D de l'unité modulaire 1 représentée sur la figure 1.

L'unité modulaire 2 comprend des rangées transversales R21 et R22 définissant trois allées A21, A22 et A23.

Préférentiellement, avant d'être amenée contre le côté droit D de l'unité 1, l'unité modulaire 2 présente des ouvertures latérales libres sur sa face gauche G et comprend sur sa face droite D, des dispositifs d'obturation 11 identiques à ceux représentés sur la figure 1. Une fois les deux modules accouplés, les jointements sont réalisés sur le contour des unités modulaires 1 et 2 afin d'assurer l'étanchéité entre les deux modules. Avantageusement, des joints seront intégrés sur les faces des modules à assembler. Lors de l'accouplage des modules, ces joints sont écrasés par serrage l'une contre l'autre des faces des deux modules. Ce serrage est typiquement assuré par l'intermédiaire de vis et de boulons.

Ensuite, les dispositifs d'obturation 11 de l'unité modulaire 1 sont démontés par l'intérieur. Ce démontage peut avoir lieu après une mise en atmosphère convenable au sein de l'unité modulaire 2 ou engendrer sa mise en atmosphère par mélange avec l'air contenu dans l'unité modulaire 1 sur laquelle l'unité 2 est alors ouverte.

Les allées sont alors directement ouvertes et prolongées. Les allées A1a, A2a sont alors mises bout à bout. Il en est de même pour les allées A1b, A2b et les allées A1c, A2c.

Dans la réalisation présentée, deux rangées sont installées transversalement. Cela résulte en 2+1=3 allées. Les ouvertures latérales sont donc, selon les principes de l'invention, au nombre de trois par face. On obtient ainsi trois allées où pourront circuler, au besoin, des opérateurs.

On note ici que l'invention peut être mise en oeuvre à partir de deux ouvertures. Avec des unités modulaires plus longues, un nombre plus important d'ouvertures pourra être utilisé. On envisage ainsi trois à huit ouvertures pour des modules selon l'invention, cela générant autant d'allées au sein de la salle informatique obtenue.

Avec trois ouvertures latérales sur chaque face de l'unité modulaire, dans le cas d'une alternance de l'utilisation d'allées chaudes et froides, on assure la présence de deux allées chaudes latérales et d'une allée froide centrale, ce qui est reconnu comme étant particulièrement intéressant pour la gestion thermique des salles informatiques.

Avantageusement, on remarque que la porte centrale présente une largeur plus importante que les portes latérales. En effet, dans le cas où trois portes 12 sont installées sur l'unité modulaire 1, cette porte centrale servira à amener des serveurs dans les rayonnages, il est donc nécessaire de pouvoir passer les dispositifs utiles pour les transporter. Ainsi, typiquement, la porte centrale présentera une largeur supérieure ou égale à un mètre alors que les portes latérales présenteront une largeur proche de 90 cm. En effet, les allées latérales ne servent pas pour la circulation des matériels mais pour gérer les connexions au besoin et, parfois, pour gérer la thermicité. En tout cas, les allées permettant de mettre en rayonnage les équipements informatiques et les allées qui permettent d'accéder à l'arrière des équipements sont compatibles, dans chaque unité modulaire selon l'invention, avec les recommandations d'exploitation des centres de données.

La figure 3 montre un agrandissement du centre de données de la figure 2 avec une troisième unité modulaire.

Cet agrandissement est réalisé à l'aide d'une troisième unité modulaire munie de dispositifs d'ouverture/fermeture permettant un accès humain sur son côté droit D et présentant des ouvertures libres sur son côté gauche G. Ce côté G présentant des ouvertures libres est amené contre le côté droit D de l'unité 2 dont les ouvertures sont munies de dispositifs d'obturation 11 ainsi que visible sur la figure 2.

Après étanchéisation, les dispositifs d'obturation 11 sont démontés par l'intérieur de la salle informatique formée préalablement par les unités 1 et 2. Une prolongation des trois allées de la salle informatique de la figure 2 est alors obtenue.

Le côté droit D de la troisième unité modulaire 3 comprend des portes 12 qui permettent à un opérateur de rentrer indifféremment d'un côté ou de l'autre du centre de données informatiques ainsi obtenu, c'est-à-dire soit par l'unité modulaire 1 soit par l'unité modulaire 3.

On remarque donc ici qu'éventuellement, le troisième module 3 pourrait être amené contre le module 2 avec des dispositifs d'obturation 11 sur son côté gauche G. Le démontage de ces dispositifs d'obturation est alors possible par l'intérieur du module 3.

La mise en oeuvre de l'invention nécessite la présence d'ouvertures alignées de part et d'autre de chaque unité et situées aux mêmes endroits d'une unité à une autre pour pouvoir les mettre en vis-à-vis. Cela assure de pouvoir ouvrir des allées parallèles et ainsi d'étendre les salles informatiques à volonté.

Dans le cas où la salle obtenue sur la figure 3 doive être agrandie, une quatrième unité modulaire sera amenée avec ouvertures libres contre les portes 12. Après accouplage et jointement des unités, soit les portes prendront une fonction séparatrice dans la salle ainsi obtenue, soit les portes seront démontées afin d'ouvrir complètement l'allée.

On voit que l'alignement des rayonnages de manière transversale par rapport à l'axe longitudinal des unités modulaires est particulièrement pertinent d'un point de vue de la construction du centre de données ainsi obtenu. En effet, on obtient finalement un alignement des rayonnages, seulement séparés par les parois des unités modulaires situées entre les ouvertures.

L'utilisation d'unités modulaires comprenant d'un côté des portes 12 démontables de l'extérieur, et, de l'autre côté, des parois amovibles 11 amovibles de l'intérieur, permet ainsi l'installation successive de plusieurs unités modulaires et la fabrication d'un seul type d'unité modulaire pour accéder à cette flexibilité.

On comprend que l'invention permet une évolution selon laquelle le client paie au fur et à mesure que sa salle informatique est agrandie, cet agrandissement étant réalisé et à partir d'unités modulaires standardisées selon l'invention.

Cela permet une approche évolutive des salles informatiques et des infrastructures liées avec une grande souplesse et une grande adaptabilité. Au sein des unités modulaires, des baies de 600 ou de 800 mm peuvent être implantées. L'invention rend actuellement possible la fourniture jusqu'à 240 KWatts/tranche de 15 m². Cette valeur peut évoluer, notamment en fonction des échangeurs air/eau disponibles.

Dans une mise en oeuvre particulière de l'invention, la largeur d'un module est de 2400mm interne minimum de façon à avoir 4x600 ou 3x800 sur chaque rangée. Les largeurs de 600 et 800 mm sont en effet les largeurs standards actuelles des rayonnages sachant que d'autres dimensions sont possibles suivant les fabricants.

La figure 4 montre un détail de l'installation des dispositifs d'obturation 11. On voit ici que le dispositif d'obturation 11 comprend une patte faisant équerre 11a, venant recouvrir un montant noté M courant sur le contour des ouvertures OG et OD.

Ce montant M peut être indifféremment utilisé pour installer le dormant du dispositif d'ouverture/fermeture permettant un accès humain 12 ou le dispositif d'obturation 11.

On voit ici que la patte 11a permet d'installer des vis traversant cette patte et s'introduisant dans le montant M de manière à maintenir le dispositif d'obturation 11 en position.

On remarque ici que le dispositif d'obturation 11 ne sera démontable que par l'intérieur de l'unité modulaire 1.

Chaque allée définit ainsi un cloisonnement. Chaque allée peut ainsi, au besoin, être isolée des autres, par exemple pour créer des espaces thermiques distincts. La possibilité de créer facilement des allées séparées d'un point de vue thermique permet la mise en oeuvre d'alternance d'allées chaudes et froides, ce qui permet une gestion d'air optimale tout en permettant un déploiement facilité de la salle informatique. Il est en effet facile d'isoler les allées les unes des autres en installant des éléments de séparation au-dessus des rangées des modules selon l'invention.

Avantageusement, dans le cas où trois allées sont installées ainsi que représenté sur la figure 3, l'allée froide AF est l'allée centrale et présente une largeur de 1200 mm et les allées chaudes AC sont latérales et présentent une largeur de 800 mm minimum pour pouvoir travailler confortablement. On retrouve ces dimensionnements sur les exemples de réalisation montrés sur les figures précédentes.

En outre, la conservation de l'isolation thermique et de la protection anti-feu est parfaitement assurée dès lors que les unités modulaires présentent ces caractéristiques.

En rendant possible l'interconnexion de nouveaux modules sans arrêt de la production, l'invention évite l'ouverture à l'air libre des unités modulaires en production, ce qui évite l'introduction d'air extérieur non filtré. Ainsi, aucune poussière ni autre corps étranger n'est introduit dans le centre de données lors de la mise en place des modules successifs et la sécurité physique du centre de données est garantie.

Typiquement, les distributions de câbles se feront selon des caractéristiques connues, par le haut des rayonnages via l'espace restant entre ces derniers et le plafond ou sous un plancher. Les câbles concernés sont de type alimentation et réseau Télécom. Avantageusement les unités modulaires selon l'invention comprennent, pour cela, des orifices 13 ainsi que décrit ci-dessus.

Des unités modulaires dédiées pourront être implémentés en fin de série de modules ou contre les faces latérales des modules pour gérer la puissance électrique, la distribution de celle-ci, l'installation d'un générateur électrique, la climatisation, ainsi que d'autres demandes spécifiques qui pourraient être formulées par des clients particuliers. Un module formant un sas d'arrivée pourra être implémenté si besoin à l'entrée d'un ensemble de modules.

On remarque enfin que diverses mises en oeuvre peuvent être réalisées selon les principes de l'invention. On note en particulier que les unités modulaires pourront être en outre empilées les unes sur les autres formant plusieurs étages de salles informatiques. Aussi des dispositifs d'obturation adaptés répondant aux principes de l'invention, c'est-à-dire l'escamotage après accouplage avec un autre module, pourront être placés entre les ouvertures prévues selon l'invention afin de pouvoir ouvrir des portions additionnelles des faces latérales pour faciliter le passage des câbles et des interconnexions courants forts/courants faibles en gardant les continuités des rayonnages selon l'invention. Les portions additionnelles escamotables pourront d'ailleurs également permettre l'installation de rayonnages intercalaires additionnels dans la continuité des allées.

## Revendications

1. Unité modulaire (1) pour la construction de centres de données informatiques de forme parallélépipédique, cette unité (1) étant destinée à être installée seule ou en groupement avec d'autres unités modulaires identiques (2,3) par un accouplage latéral réalisé sur la longueur des unités modulaires (1,2,3), cette unité (1) comprenant, au sein de son espace interne, au moins une rangée de rayonnages (R11,R12) aptes à recevoir des appareillages informatiques actifs et passifs, cette rangée (R11,R12) étant aménagée dans la largeur de l'unité modulaire (1) et définissant ainsi au moins un nombre d'allées (A1a,A1b,A1c) parallèles égal au nombre de rangées plus une, ces allées (A1a,A1b,A1c) étant séparées par la ou lesdites rangée(s) (R11,R12), **caractérisé en ce que** l'unité modulaire (1) comprend en outre autant d'ouvertures latérales (ODa,ODb,ODc, OGa,OGb,OGc) que d'allées (A1a,A1b,A1c) de part et d'autre de l'unité modulaire (1), et **en ce que** ces ouvertures (ODa,ODb,ODc, OGa,OGb,OGc) sont aptes à être équipées soit par un dispositif d'ouverture/fermeture (12) permettant un accès humain à l'allée correspondante, soit par un dispositif d'obturation (11) démontable après l'accouplage avec une autre unité modulaire (2) et après jointement des deux unités modulaires (1,2) pour permettre d'ouvrir la circulation dans les deux allées correspondantes (A1a,A2a,A1b,A2b,A1c,A2c) des deux unités modulaires (1,2) accouplées qui sont alors dans la continuité l'une de l'autre.

2. Unité modulaire selon la revendication 1, **caractérisé en ce qu'**elle présente un dimensionnement parallélépipédique externe satisfaisant, au moins en longueur, à l'un des standards dimensionnels en vigueur pour les containers de transport de marchandises ou pour les bungalows de chantier.

3. Unité modulaire selon l'une des revendications 1 et 2, **caractérisée en ce que** les dispositifs d'obturation (11) sont démontables par l'intérieur de l'unité modulaire (1).

4. Unité modulaire selon l'une des revendications précédentes, **caractérisé en ce que** la ou les rangées (R11,R12,R21,R22) est(sont) telle(s) que les allées (A1a,A2a,A1b,A2b,A1c,A2c) sont ouvertes les unes sur les autres et définissent ainsi un seul espace thermique continu et confiné.

5. Unité modulaire selon l'une des revendications 1 à 3, **caractérisé en ce que** la ou les rangées (R11,R12,R21,R22) est(sont) telle(s) que les allées (A1a,A2a,A1b,A2b,A1c,A2c) sont isolées les unes des autres, les allées (A1a,A2a) (A1b,A2b) (A1c,A2c) définissant alors des espaces thermiques distincts.

6. Unité modulaire selon la revendication 5, **caractérisé en ce que** les appareillages informatiques sont disposés dans les rayonnages de telle manière que les allées sont en alternance chaudes et froides (AC,AF) sur la longueur de l'unité modulaire (1).

7. Unité modulaire selon la revendication 6, **caractérisé en ce que** la répartition des ouvertures latérales (ODa,ODb,ODc, OGa,OGb,OGc) est telle que, sur des longueurs successives de 5 à 7 mètres, le nombre d'ouvertures latérales est de trois.

8. Procédé de construction d'un centre de données informatiques évolutif, comprenant les étapes suivantes :
- installation d'une première unité modulaire (1) selon l'une des revendications précédentes, les ouvertures latérales (ODa,ODb,ODc, OGa,OGb,OGc) de cette unité (1) étant munies, d'un côté, de dispositifs d'ouverture/fermeture (12), et de l'autre côté, de dispositifs d'obturation (11) démontables ;
- mise en atmosphère convenable de l'espace interne de la première unité modulaire (1) ;
- installation et mise en route d'appareillages informatiques ;
les étapes suivantes étant réalisées en fonction des besoins d'évolution du centre de données, sans nécessiter d'arrêt interruption de fonctionnement des appareillages informatiques installés dans la première unité modulaire (1) déjà installées et assemblées :
- amenée d'une deuxième unité modulaire (2) selon l'une des revendications précédentes, présentant le même nombre d'ouvertures (ODa,ODb,ODc, OGa,OGb,OGc) que la première unité (1), latéralement contre la face de la première unité modulaire (1) munie de dispositifs d'obturation (11), cette deuxième unité modulaire (2) étant munie, sur la face opposée à la face amenée contre la première unité modulaire (1), soit de dispositifs d'obturation (11), soit de dispositifs d'ouverture/fermeture (12) ;
- accouplage des deux unités modulaires (1,2) avec jointement au niveau des deux faces amenées l'une contre l'autre ;
- interconnexion des réseaux électriques, hydrauliques et de contrôle des deux unités sans arrêter le fonctionnement de l'unité déjà en fonction ;
- démontage des dispositifs d'obturation (11) avant ou après une mise en atmosphère convenable de l'espace interne de la deuxième unité modulaire (2).

9. Centre de données informatiques comprenant une pluralité d'unités modulaires selon l'une des revendications 1 à 7 et obtenu selon le procédé de la revendication 8, ce centre de données présentant une pluralité d'allées (A1a,A2a,A1b,A2b,A1c,A2c) parallèles transversales aux axes longitudinaux des unités modulaires (1,2,3), ces allées (A1a,A2a,A1b,A2b,A1c,A2c) étant ouvertes au travers des ouvertures (ODa,ODb,ODc, OGa,OGb,OGc) des unités modulaires (1,2,3) dépourvues de dispositifs d'obturation (11) et de dispositifs d'ouverture/fermeture (12).

## Patentansprüche

1. Modulare Einheit (1) für den Bau von IT-Datenzentren in Parallelepipedform, wobei diese Einheit (1) dazu bestimmt ist, allein oder in einer Gruppierung mit anderen identischen modularen Einheiten (2, 3) durch seitliches Koppeln, das auf der Länge der modularen Einheiten (1, 2, 3) ausgeführt wird, installiert zu werden, wobei diese Einheit (1) in ihrem Innenraum mindestens eine Regalreihe (R11, R12) aufweist, die geeignet ist, um aktive und passive Informatikausstattungen aufzunehmen, wobei diese Reihe (R11, R12) in die Breite der modularen Einheit (1) eingerichtet ist und daher mindestens eine Anzahl paralleler Gänge (A1a, A1b, A1c) gleich der Anzahl von Reihen plus eine bildet, wobei diese Gänge (A1a, A1b, A1c) durch die Reihe(n) (R11, R12) getrennt sind, wobei die modulare Einheit (1) ferner ebenso viele seitliche Öffnungen (ODa, ODb, ODc, OGa, OGb, OGc) wie Gänge (A1a, A1b, A1c) zu beiden Seiten der modularen Einheit (1) aufweist, wobei diese Öffnungen (ODa, ODb, ODc, OGa, OGb, OGc) geeignet sind, um entweder mit einer Öffnungs/Schließvorrichtung (12), die einen Personalzugang zu dem entsprechenden Gang erlaubt, oder durch eine Verschlussvorrichtung (11), die nach dem Koppeln mit einer anderen modularen Einheit (2) und nach Verbinden der zwei modularen Einheiten (1, 2) demontierbar ist, um das Öffnen der Zirkulation in den zwei entsprechenden Gängen (A1a, A2a, A1b, A2b, A1c, A2c) der zwei gekoppelten modularen Einheiten (1, 2), die daher eine hinter der anderen liegen, zu erlauben, ausgestattet zu werden.

2. Modulare Einheit nach Anspruch 1, **dadurch gekennzeichnet, dass** sie eine externe parallelepipedische Bemaßung aufweist, die mindestens in der Länge eine der maßlichen Normen, die für Gütertransportcontainer oder für Baucontainer gelten, erfüllt.

3. Modulare Einheit nach einem der Ansprüche 1 und 2, **dadurch gekennzeichnet, dass** die Verschlussvorrichtungen (11) vom Inneren der modularen Einheit (1) her demontierbar sind.

4. Modulare Einheit nach einem der vorhergehenden Ansprüche, **dadurch gekennzeichnet, dass** die Reihe oder die Reihen (R11, R12, R21, R22) derart ist/sind, dass die Gänge (A1a, A2a, A1b, A2b, A1c, A2c) einer auf den anderen geöffnet sind und daher einen kontinuierlichen und eingeschlossenen thermischen Raum bilden.

5. Modulare Einheit nach einem der Ansprüche 1 bis 3, **dadurch gekennzeichnet, dass** die Reihe oder Reihen (R11, R12, R21, R22) derart ist/sind, dass die Gänge (A1a, A2a, A1b, A2b, A1c, A2c) voneinander isoliert sind, wobei die Gänge (A1a, A2a) (A1b, A2b) (A1c, A2c) daher getrennte thermische Räume bilden.

6. Modulare Einheit nach Anspruch 5, **dadurch gekennzeichnet, dass** die EDV-Ausstattungen in den Regalen derart angeordnet sind, dass die Gänge auf der Länge der modularen Einheit (1) abwechselnd warm und kalt (AC, AF) sind.

7. Modulare Einheit nach Anspruch 6, **dadurch gekennzeichnet, dass** die Verteilung der seitlichen Öffnungen (ODa, ODb, ODc, OGa, OGb, OGc) derart ist, dass die Anzahl seitlicher Öffnungen auf aufeinanderfolgenden Längen von 5 bis 7 Meter gleich drei ist.

8. Verfahren zum Bauen eines entwicklungsfähigen IT-Datencenters, das die folgenden Schritte aufweist:
- Installation einer ersten modularen Einheit (1) nach einem der vorhergehenden Ansprüche, wobei die seitlichen Öffnungen (ODa, ODb, ODc, OGa, OGb, OGc) dieser Einheit (1) auf einer Seite mit Öffnungs-/Schließvorrichtungen (12) und auf der anderen Seite mit abnehmbaren Verschlussvorrichtungen (11) versehen sind,
- geeignete Belüftung des Innenraums der ersten modularen Einheit (1),
- Installation und Inbetriebnahme von Informatikausstattungen,
wobei die folgenden Schritte in Abhängigkeit von den Entwicklungserfordernissen des Datencenters ausgeführt werden, ohne dass eine Betriebsunterbrechung der Informatikausstattungen, die in der ersten modularen Einheit (1) installiert sind, die bereits installiert und zusammengefügt sind, erforderlich ist:
- Zuführung einer zweiten modularen Einheit (2) nach einem der vorhergehenden Ansprüche, die dieselbe Anzahl von Öffnungen (ODa, ODb, ODc, OGa, OGb, OGc) wie die erste Einheit (1) aufweist, seitlich gegen die Fläche der ersten modularen Einheit (1), die mit Verschlussvorrichtungen (11) versehen ist, wobei diese zweite modulare Einheit (2) auf der Fläche, die der Zuführungsfläche gegen die erste modulare Einheit (1) gegenüber liegt, entweder mit Verschlussvorrichtungen (11) oder mit Öffnungs-/Schließvorrichtungen (12) versehen ist,
- Koppeln der zwei modularen Einheiten (1, 2) eine gegen die andere mit Verbinden auf dem Niveau der zweiten Zuführungsfläche,
- Zusammenschaltung der Strom-, Hydraulik- und Steuernetze der zwei Einheiten ohne Stoppen des Betriebs der bereits in Betrieb befindlichen Einheit,
- Demontage der Verschlussvorrichtungen (11) vor oder nach einer geeigneten Belüftung des Innenraums der zweiten modularen Einheit (2).

9. IT-Datencenter, das eine Vielzahl modularer Einheiten nach einem der Ansprüche 1 bis 7 aufweist und gemäß dem Verfahren des Anspruchs 8 erzielt wird, wobei dieses Datencenter eine Vielzahl paralleler Gänge (A1a, A2a, A1b, A2b, A1c, A2c), die zu den Längsachsen der modularen Einheiten (1, 2, 3) quer liegen, aufweist, wobei diese Gänge (A1a, A2a, A1b, A2b, A1c, A2c) durch Öffnungen (ODa, ODb, ODc, OGa, OGb, OGc) der modularen Einheiten (1, 2, 3), die keine Verschlussvorrichtungen (11) und Öffnungs-/Schließvorrichtungen (12) aufweisen, offen sind.

## Claims

1. Modular unit (1) of parallelepiped-shape for constructing computing data centres, the unit (1) being destined to be installed on its own or in a group with other identical modular units (2,3) by means of lateral coupling along the length of the modular units (1,2,3), the unit (1) comprising, inside the unit, at least one row (R11,R12) of racks suitable for receiving active and passive computing apparatuses , the row (R11,R12) being arranged along the width of the modular unit (1) and thus defining at least a number of parallel aisles (A1a,A1b,A1c) equal to the number of rows plus one, the aisles (A1a,A1b,A1c) being separated by said row(s) (R11,R12), **characterised in that** the modular unit (1) further comprises as many side openings (ODa,ODb,ODc, OGa,OGb,OGc) as aisles (A1a,A1b,A1c) at both ends of the modular unit (1), and **in that** these openings (ODa,ODb,ODc, OGa,OGb,OGc) are suitable for being equipped either with an opening/closing device (12) enabling a human to access the corresponding aisle, or with a sealing device (11) that can be removed after coupling with another modular unit (2) and after joining of the two modular units (1,2) to open up circulation in the two corresponding aisles (A1a,A2a,A1b,A2b,A1c,A2c) of the two coupled modular units (1,2) which are thus aligned with each other.

2. Modular unit according to claim 1, **characterised in that** it has an external parallelepiped-shaped design in compliance with, at least in respect of length, any one of the applicable dimensional standards for goods transportation containers or for worksite cabins.

3. Modular unit according to any of claims 1 and 2, **characterised in that** the sealing devices (11) are suitable for being removed from inside the modular unit (1).

4. Modular unit according to any of the above claims, **characterised in that** the row(s) (R11,R12,R21,R22) is(are) such that the aisles (A1a,A2a,A1b,A2b,A1c,A2c) are open unto each other and thus define a continuous and confined single thermal space.

5. Modular unit according to any of claims 1 to 3, **characterised in that** the row(s) (R11,R12,R21,R22) is(are) such that the aisles (A1a,A2a,A1b,A2b,A1c,A2c) are isolated from each other, the aisles (A1a,A2a) (A1b,A2b) (A1c,A2c) thus defining separate thermal spaces.

6. Modular unit according to claim 5, **characterised in that** the computing apparatuses are arranged in the racks such that the aisles are alternately hot and cold (AC,AF) along the length of the modular unit (1).

7. Modular unit according to claim 6, **characterised in that** the distribution of the side openings (ODa,ODb,ODc, OGa,OGb,OGc) is such that, over successive lengths of 5 to 7 metres, the number of side openings is three.

8. Method for constructing a modular computing data centre, comprising the following steps:
- installing a first modular unit (1) according to any of the preceding claims, the side openings (ODa,ODb,ODc, OGa,OGb,OGc) of the unit (1) being equipped, on one side, with opening/closing devices (12), and on the other side, with removable sealing devices (11);
- setting suitable atmospheric conditions inside the first modular unit (1);
- installing and starting up computing apparatuses;
the following steps being carried out according to data centre scaling requirements, without requiring any shutdown or interruption in the operation of the computing apparatuses installed in the previously installed and assembled first modular unit (1):
- positioning a second modular unit (2) according to any of the preceding claims, having the same number of openings (ODa,ODb,ODc, OGa,OGb,OGc) as the first unit (1), laterally against the side of the first modular unit (1) equipped with sealing devices (11), the second modular unit (2) being equipped, on the side opposite the side positioned against the first modular unit (1), either with sealing devices (11) or opening/closing devices (12);
- coupling the two modular units (1,2) by joining the two sides positioned against each other;
- interconnecting the electrical, hydraulic and control networks of both units without shutting down the operation of the unit already in use;
- removing the sealing devices (11) before or after setting suitable atmospheric conditions inside the second modular unit (2).

9. Computing data centre comprising a plurality of modular units according to one of claims 1 to 7 and obtained according to the method in claim 8, the data centre having a plurality of transverse parallel aisles (A1a,A2a,A1b,A2b,A1c,A2c) relative to the longitudinal axes of the modular units (1,2,3), the aisles (A1a,A2a,A1b,A2b,A1c,A2c) being open via openings (ODa,ODb,ODc, OGa,OGb,OGc) of the modular units (1,2,3) devoid of sealing devices (11) and opening/closing devices (12).
